(19) Europäisches Patentamt / European Patent Office / Office européen des brevets

(11) **EP 3 373 019 B1**

(12) **EUROPEAN PATENT SPECIFICATION**

(45) Date of publication and mention
of the grant of the patent:
**19.10.2022 Bulletin 2022/42**

(21) Application number: **16861543.3**

(22) Date of filing: **01.11.2016**

(51) International Patent Classification (IPC):
**G01R 31/26** (2020.01)    **G01K 7/01** (2006.01)

(52) Cooperative Patent Classification (CPC):
**G01R 31/26**

(86) International application number:
**PCT/CN2016/104228**

(87) International publication number:
**WO 2017/076275 (11.05.2017 Gazette 2017/19)**

(54) **DEVICE AND METHOD FOR ONLINE HEALTH MANAGEMENT OF INSULATED GATE BIPOLAR TRANSISTOR**

VORRICHTUNG UND VERFAHREN FÜR ONLINE-GESUNDHEITSMANAGEMENT EINES BIPOLAREN TRANSISTORS MIT ISOLIERTEM GATE

DISPOSITIF ET PROCÉDÉ DE GESTION EN LIGNE DE SANTÉ DE TRANSISTOR BIPOLAIRE À GRILLE ISOLÉE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **05.11.2015 CN 201510745148**

(43) Date of publication of application:
**12.09.2018 Bulletin 2018/37**

(73) Proprietor: **CRRC Zhuzhou Institute Co., Ltd.**
**Zhuzhou, Hunan 412001 (CN)**

(72) Inventors:
 • **LIU, Wenye**
  **Zhuzhou**
  **Hunan 412001 (CN)**
 • **YANG, Jinfeng**
  **Zhuzhou**
  **Hunan 412001 (CN)**
 • **HU, Jiaxi**
  **Zhuzhou**
  **Hunan 412001 (CN)**
 • **LI, Yanyong**
  **Zhuzhou**
  **Hunan 412001 (CN)**
 • **LUO, Jianbo**
  **Zhuzhou**
  **Hunan 412001 (CN)**
 • **FU, Hangjie**
  **Zhuzhou**
  **Hunan 412001 (CN)**

(74) Representative: **Hoffmann Eitle**
**Patent- und Rechtsanwälte PartmbB**
**Arabellastraße 30**
**81925 München (DE)**

(56) References cited:
CN-A- 102 253 320    CN-A- 102 636 291
CN-A- 103 809 098    CN-A- 104 933 308
CN-A- 104 933 308    CN-A- 105 486 992
DE-A1-102011 087 764   JP-A- 2006 254 574
JP-A- 2007 028 741    US-B2- 8 103 463

**Description**

FIELD OF THE INVENTION

The present disclosure relates to the technical field of electronic circuit, and in particular, to an on-line health management device and an on-line health management method for an insulated gate bipolar transistor.

BACKGROUND OF THE INVENTION

With progress in scientific researches and technologies and improvements in manufacturing processes, an insulated gate bipolar transistor (IGBT), as an ideal switch element in the field of power electronics, has been widely used in many key areas, such as new energy power generation, locomotive traction, and high-voltage transmission. With application of new structures and new technologies of power semiconductors, an electric current density and a withstand voltage level of the IGBT constantly increase. Meanwhile, as size of the IGBT becomes smaller and smaller, the IGBT bears increasingly high electrical, mechanical and thermal loads. A great deal of heat is generated when the IGBT operates in a high power state, and thus a temperature rise and a thermal stress deformation are caused.

During long-time operation, the IGBT continuously bears temperature changes and power cycling, which accelerates a fatigue failure process thereof. An IGBT failure may cause interruption of entire equipment, or even results in serious safety accidents and big economic losses. Therefore, how to detect a lifetime of the IGBT during a working process so as to know an operating state and reliability thereof becomes more and more important.

DE102011087764A1 discloses a method for determining service life consumption of e.g. insulated gate bipolar transistor in wind energy plant, involves determining characteristics of temperature cycles, and determining service life consumption based on cycles.

US8103463B2 discloses systems and methods for predicting failure of electronic systems and assessing level of degradation and remaining useful life. Such systems and methods present challenges traditionally viewed as either insurmountable or otherwise not worth the cost of pursuit.

JP2007028741A discloses a power converter and its management system. This power converter has a temperature fluctuation band estimator which estimates the amount of temperature fluctuations of a power semiconductor switching element from the input current or the output current of itself, a number-of-times-of-thermal-fatigue-cycle converter which converts the output value of the temperature fluctuation band estimator into the number of times of thermal fatigue cycles of a reference temperature difference, and a notification system which computes the extent of deterioration of the power semiconductor switching element from the number of times of the thermal cycles and notifies it to the maintenance manager or the owner of the power converter.

CN104933308A discloses a reliability assessment method oriented to domestic military IGBT (Insulated Gate Bipolar Translator) module. The method comprises the following steps: acquiring a chip junction temperature, an encapsulation temperature, a temperature variation amplitude and an annual temperature cycle index; matching a chip temperature stress coefficient, an encapsulation temperature stress coefficient and an encapsulation temperature stress coefficient corresponding to a domestic military IGBT; and acquiring the failure rate of the module in order to obtain a reliability assessment result.

SUMMARY OF THE INVENTION

The present invention is defined in the appended independent claims. Further preferred embodiments are defined in the dependent claims. The present disclosure aims to provide an on-line health management device and an on-line health management method for an insulated gate bipolar transistor (IGBT) so as solve a technical problem in the prior art that a lifetime of the IGBT cannot be detected during operation thereof.

According to a first aspect, the present disclosure provides an on-line health management device for an insulated gate bipolar transistor. The on-line health management device comprises: an electrothermal detection module, configured to detect a junction temperature and a temperature rise of the insulated gate bipolar transistor based on operating condition parameters of the insulated gate bipolar transistor in combination with a structure of the insulated gate bipolar transistor; a degradation detection module, configured to detect a performance degradation degree of the insulated gate bipolar transistor based on the operating condition parameters, the structure, the junction temperature and the temperature rise of the insulated gate bipolar transistor; and a lifetime detection module, configured to detect a consumed lifetime of the insulated gate bipolar transistor based on the performance degradation degree thereof.

The on-line health management device further comprises: a sampling module, configured to sample the operating condition parameters of the insulated gate bipolar transistor; and an extremum detection module, configured to detect whether the operating condition parameters each are within a corresponding extremum range or not. If the operating condition parameters each are within a corresponding extremum range, the operating condition parameters are sent to the electrothermal detection module.

Preferably, the on-line health management device further comprises: a warning module, configured to detect whether the consumed lifetime is larger than or equal to a preset lifetime. If the consumed lifetime is larger than or equal to the preset lifetime, a failure warning is provided.

Preferably, if the extremum detection module detects that an operation condition parameter is beyond a corresponding extremum range, a detection result is sent to the warning module; and the warning module is further configured to provide a failure warning based on the detection result of the extremum detection module.

Preferably, the operating condition parameters at least include current, voltage, and working temperature.

Preferably, the degradation detection module is configured to detect the performance degradation degree of the insulated gate bipolar transistor based on failure working cycles corresponding to the operating condition parameters, the structure, the junction temperature and the temperature rise of the insulated gate bipolar transistor in combination with fusion operators corresponding to the operating condition parameters, the structure, the junction temperature and the temperature rise of the insulated gate bipolar transistor.

The present disclosure brings about following beneficial effects. The present disclosure provides an on-line health management device for an IGBT. The on-line health management device detects a lifetime state of the IGBT based on the operating condition parameters of the IGBT in combination with the structure of the IGBT so as to feed lifetime state of the IGBT back to the user and remind the user to maintain or replace the IGBT in time, thereby ensuring a normal working of equipment with the IGBT.

According to a second aspect, the present disclosure provides an on-line health management method for an insulated gate bipolar transistor. The on-line health management method comprises steps of: detecting a junction temperature and a temperature rise of the insulated gate bipolar transistor based on operating condition parameters of the insulated gate bipolar transistor in combination with a structure of the insulated gate bipolar transistor; detecting a performance degradation degree of the insulated gate bipolar transistor based on the operating condition parameters, the structure, the junction temperature and the temperature rise of the insulated gate bipolar transistor; and detecting a consumed lifetime of the insulated gate bipolar transistor based on the performance degradation degree thereof.

Preferably, the on-line health management method further comprises a step of: detecting an operation state of the insulated gate bipolar transistor based on the performance degradation degree.

Preferably, before the step of detecting the junction temperature and the temperature rise of the insulated gate bipolar transistor based on the operating condition parameters of the insulated gate bipolar transistor in combination with the structure of the insulated gate bipolar transistor, the on-line health management method further comprises steps of: sampling the operating condition parameters of the insulated gate bipolar transistor; and detecting whether the operating condition parameters each are within a corresponding extremum range or not. If the operating condition parameters each are within a respective corresponding extremum range, the operating condition parameters are sent to the electrothermal detection module.

Preferably, if it is detected that an operation condition parameter is beyond a corresponding extremum range, the on-line health management method further comprises a step of: providing a failure warning based on a detection result of the extremum detection module.

Other features and advantages of the present disclosure will be further explained in the following description, and partially become self-evident therefrom, or be understood through implementing the present disclosure. The objectives and other advantages of the present disclosure will be achieved through the structure specifically pointed out in the description, claims, and the accompanying drawings.

BRIEF DESCRIPTION OF THE DRAWINGS

The accompanying drawings provide further understandings of the present disclosure, and constitute one part of the description. The drawings are used for interpreting the present disclosure together with the embodiments, not for limiting the present disclosure. In the drawings:

Fig. 1 schematically shows a structure of an on-line health management device for an insulated gate bipolar transistor according to an embodiment of the present disclosure;

Fig. 2 schematically shows a structure of an insulated gate bipolar transistor according to an embodiment of the present disclosure; and

Fig. 3 is a flow chart of an on-line health management method for an insulated gate bipolar transistor according to an embodiment of the present disclosure.

DETAILED DESCRIPTION OF THE EMBODIMENTS

The present disclosure will be explained in detail with reference to the accompanying drawings so as to make the purpose, the technical solution and advantages of the present disclosure clearer.

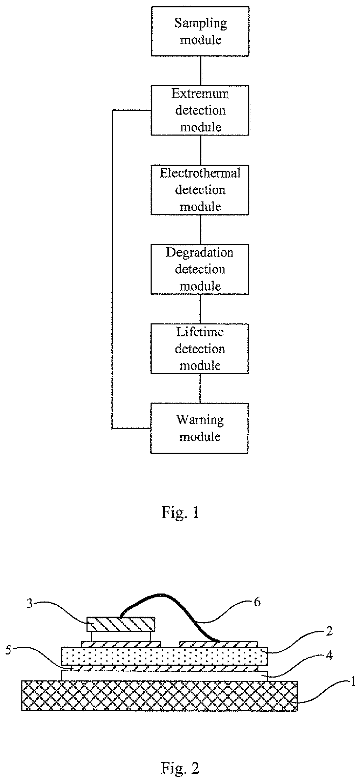

The present disclosure provides an on-line health management device for an insulated gate bipolar transistor (IGBT). Specifically, as shown in Fig. 1, the on-line health management device comprises a sampling module, an extremum detection module, an electrothermal detection module, a degradation detection module, a lifetime detection module, and a warning module.

Specifically, as shown in Fig. 2, the IGBT comprises, from bottom to top, a copper base plate 1, a substrate 2, a Si chip 3 and so on. A solder layer 4 for fixing the substrate 2 and the Si chip 3 on the copper base plate 1 is provided between the copper base plate 1 and the substrate 2 as well as between the substrate 2 and the Si chip 3. The Si chip 3 is fixed on a copper coating layer 5 on one surface of the substrate 2 via the solder layer 4, and the other surface of the substrate 2, which faces the copper base plate 1, is also covered by a copper coating layer 5. The Si chip 3 is further provided thereon with an aluminum bonding wire 6, which electrically connects the Si chip 3 and a copper coating layer 5 which is on the same surface of the substrate 2 as the Si chip 3.

IGBTs with different structures and different material configurations have different failure mechanisms. Therefore, a detection device of the IGBT provided by the embodiment of the present disclosure should perform a comprehensive and all-round detection to the IGBT so as to obtain a precise detection result.

In the present embodiment, the sampling module comprises a plurality of sensors for detecting and sampling operating condition parameters of the IGBT, and at least comprises sensors for respectively detecting working temperature, voltage and current of the IGBT. Besides, in order to obtain a more precise detection result, the sampling module can further comprise sensors for detecting parameters of the IGBT, such as working altitude, relative humidity, and vibration intensity.

If the IGBT works under relatively extreme operating condition parameters, it indicates that the IGBT cannot work effectively, or even faces an imminent failure. The detection device in the present embodiment further comprises an extremum detection module. The extremum detection module is configured to detect whether the operating condition parameters each are within a corresponding extremum range, i.c., whether the IGBT is within a safe operating area. Safe operating areas mainly include a forward bias safe operating area, a reverse bias safe operating area and a short circuit safe operating area, and operating areas of a device should all meet restriction requirements of corresponding safe operating areas. Specifically, an IGBT as an ordinary power device and an IGBT as a traction power device have different extremum ranges which are shown in the following Table 1.

Table 1

| Requirements | Ordinary power device | Traction power device |
|---|---|---|
| Working altitude | $\leq 1000$ m | $\leq 4000$ m |
| Working temperature | 0°C ~ +40°C | -40°C - +55°C |
| Relative humidity | 5% - 85% | $\leq 95\%$ |
| Voltage fluctuation | +/-10% | +/- 24% |
| Vibration intensity | X\Y\Z axis < 10 m/s$^2$ | X axis 30 m/s$^2$<br>Y axis 30 m/s$^2$<br>Z axis 50 m/s$^2$ |

If the extremum detection module detects that one of the operating condition parameters, for example, temperature, goes beyond an extremum range thereof, it indicates that the solder layer 4 within the IGBT is at a risk of fusion at this time, which causes the IGBT to be at a risk of failure. Then, the warning module pops up a corresponding warning reminder to a user, and the IGBT stops working temporarily.

On the contrary, if the extremum detection module detects that the operating condition parameters each are within a corresponding extremum range, the extremum detection module sends the operating condition parameters to the electrothermal detection module. Based on the operating condition parameters in combination with a structure of the IGBT, the electrothermal detection module detects a junction temperature and a temperature rise of the IGBT. The electrothermal detection module comprises a power loss model and a thermal modal, and detects the junction temperature and the temperature rise of the IGBT mainly by detecting power loss and thermal loss of the IGBT. The power loss model represents a property that the power loss changes with the voltage, the current and the temperature during operation of the IGBT, i.e., the temperature rise. The thermal model represents a thermal conduction property of a path through which the power loss of the IGBT flows in a form of heat, and is a key model for assessing the junction temperature of a power device.

It should be explained that, the structure of the IGBT combined by the electrothermal detection module is set and stored in advance in a database of the on-line health management device by the user, which can be used directly by the electrothermal detection module when needed, instead of a specific structure detected in real time.

Specifically, according to the power loss model, the power loss of the IGBT is calculated by a following formula: $P_{Tr\_tot} = P_{cond\_Tr} + P_{sw\_Tr\_on} + P_{sw\_Tr\_off}$, in which $P_{cond\_Tr}$ is on-state loss of the IGBT, $P_{sw\_Tr\_on}$ is switch-on loss of the IGBT, and $P_{sw\_Tr\_off}$ is switch-off loss of the IGBT. Power loss of a diode is calculated by a following formula: $P_{D\_tot} = P_{cond\_D} + P_{sw\_D\_off}$, in which $P_{cond\_D}$ is on-state loss of the diode, and $P_{sw\_D\_off}$ is switch-on/off loss of the diode.

The power loss generated during operation of the IGBT flows in the form of heat in a device, but a property of a heat dissipation path of the IGBT directly affects the junction temperature and lifetimes of materials of respective layers of the IGBT. During a heat conduction process, inconsistent coefficients of thermal expansion (CTE) of materials will cause a thermal stress, and thus performance degradation of the materials will occur. By means of the thermal model, thermal response circumstances of the device under different conditions of heat dissipation and conduction paths can be described, and therefore an assessing for a thermal design solution of a system can be provided. An equivalent circuit structure of the IGBT is set through a thermal transient experiment. Generally, a thermal resistance, a thermal capacity and so on are used to express a dynamic response action of a thermal conduction process, and a thermal response action of the IGBT can be expressed by a following formula:

$$Z_{th}(t) = \sum_{i=1}^{n} R_{thi} \cdot \left[1 - \exp\left(-\frac{t}{R_{thi} \cdot C_{thi}}\right)\right],$$

wherein $R_{thi}$ is an $i^{th}$-order thermal resistance, and $C_{thi}$ is an $i^{th}$-order thermal capacity.

As shown in Fig. 1, the detection device provided in the present embodiment further comprises a degradation detection module which is configured to detect a performance degradation degree of the IGBT based on the operating condition parameters, the structure of the IGBT, the junction temperature and the temperature rise of the IGBT. In a normal operating condition, respective parts of the IGBT bear different stresses, and meanwhile respective components of the device are formed by different materials.

Accordingly, with respect to different stresses, action properties of various materials are different. For example, with respect to a mechanical stress, various materials show different strain and fatigue properties; and with respect to a temperature stress, different materials show different CTEs.

Therefore, the degradation detection module in the present embodiment can be used to perform a statistic treatment to cycle times of temperatures and stresses so as to obtain corresponding failure cycles of different temperatures and stresses, and further a degradation degree of the IGBT can be better assessed. A process of the statistic treatment to the cycle times of the temperatures and the stresses normally comprises two steps. In step 1, a procedure of pretreating stress information is performed. That is, curves of temperatures and stresses changing over time are converted, by a pretreating technology, into a group of fold lines having amplitudes changing over time. In step 2, a statistic algorithm is used to calculate the cycle times of given temperature and stress spectra. Typically, a rainflow-counting algorithm is used. All fluctuation amplitudes in an entire fold line is divided into a plurality of equidifferent amplitude levels according to a certain rule, and then cycle times corresponding to respective amplitude levels are obtained by a statistical analysis. Finally, a statistic result of loads in a temperature-frequency form is obtained, which provides data support for a subsequent calculation of fatigue loss of the device and assessment of a lifetime thereof.

In addition, since an IGBT failure process is a result of combined action of multiple factors, degradation behaviors represented by the IGBT are different under different stresses. With continuous improvements of packaging technologies, a lifetime of the IGBT has been greatly prolonged. At present, fatigue of the solder layer 4 and fall-off of the aluminum bonding wire 6 have become two main failure mechanisms.

The present disclosure provides a multi-parameter degradation model including a series of affection factors based on a great number of reliable experiments. The multi-parameter degradation model is expressed by a following formula:

$$N_f = FUN(\Delta T_J, T_J, I, V, D),$$

wherein the working cycles of the device before a failure can be expressed by a functional relationship of a junction temperature $T_J$, a temperature rise $\Delta T_J$, a current I, a voltage V, and an aluminum bonding wire geometrical dimension S.

In the present embodiment, information fusion technology is used for a comprehensive processing and analysis to information of the device collected from different aspects. Based on this, a degradation degree and state of the device can be obtained in real time. That is, an analyzing and processing can be performed based on "big data".

The information fusion technology is a multi-source information comprehensive processing technology. According to the information fusion technology, information in a same form or different forms measured at a same time point or different time points provided by a plurality of sensors having a same type or different types in a system are analyzed, processed and synthesized so as to obtain a comprehensive and consistent estimation of a measured object. A more precise and complete conclusion can be obtained based on a result of a multi-source information fusion than a single information source.

Specifically, the multi-parameter degradation model is expressed by a following formula:

$$N_f = K_1 \times N_1(\Delta T_J) + K_2 \times N_2(T_J) + K_3 \times N_3(I) + K_4 \times N_4(V) + K_5 \times N_5(S),$$

wherein, $N_i$ refers to the working cycles of the device corresponding to different failure factors, $K_i$ refers to fusion operators (i.e., proportions) corresponding to different failure factors, and other signs are the same as the aforementioned ones respectively. Specifically, $N_1$ represents working cycles of the device corresponding to the temperature rise $\Delta T_J$, and $K_1$ is a fusion operator corresponding to the temperature rise $\Delta T_J$; $N_2$ represents working cycles of the device corresponding to the junction temperature $T_J$, and $K_2$ is a fusion operator corresponding to the junction temperature $T_J$; $N_3$ represents working cycles of the device corresponding to the current I, and $K_3$ is a fusion operator corresponding to the current I; $N_4$ represents working cycles of the device corresponding to the voltage V, and $K_4$ is a fusion operator corresponding to the voltage V; $N_5$ represents working cycles of the device corresponding to the aluminum bonding wire geometrical dimension S, and $K_5$ is a fusion operator corresponding to the aluminum bonding wire geometrical dimension S.

Obviously, the performance degradation degree of the IGBT is not caused by one factor or two factors. The working process of the IGBT needs to be studied and understood carefully, and actions of respective potential factors need to be considered comprehensively. Influences of respective potential factors to performance of the IGBT should be analyzed separately, and multiple factors which have an influence on the performance of the IGBT can be obtained finally. Therefore, a comprehensive action of multiple factors should be combined during detection of the IGBT, so that the performance degradation degree of the IGBT can be detected more scientifically and precisely.

Then, the lifetime detection module of the present embodiment can detect a consumed lifetime of the IGBT based on a precise performance degradation degree thereof. It can be known from Miller linear damage accumulation theory that, each temperature cycle and power cycle will cause certain damage to the lifetime of the IGBT. When the damage accumulates to a certain amount, a failure of the IGBT is caused finally.

The consumed lifetime of the IGBT can be calculated and assessed by a following formula. When $D \geq 1$, it means that the IGBT fails.

$$T = \frac{1}{D}, \text{ and } D = \sum_{i=1}^{n} \frac{n_i}{N_{f_i}}$$

In the formula, $n_i$ represents consumption times corresponding to each junction temperature and temperature rise, and $N_{fi}$ represents theoretical consumption times of the lifetime corresponding to each junction temperature and temperature rise.

When it is detected that the consumed lifetime is larger than or equal to a preset lifetime, i.e., when $D \geq 1$, the warning module provides a failure warning. That is, the user is reminded to replace the IGBT by a special warning bell or by a warning window popped up on a user monitoring interface.

To sum up, the present embodiment provides an on-line health management device for the IGBT. The on-line health management device detects a lifetime state of the IGBT based on operating condition parameters of the IGBT in combination with the structure of the IGBT so as to provide feed the lifetime state of the IGBT back to the user and remind the user to maintain or replace the IGBT in time, thereby ensuring a normal working of equipment with the IGBT.

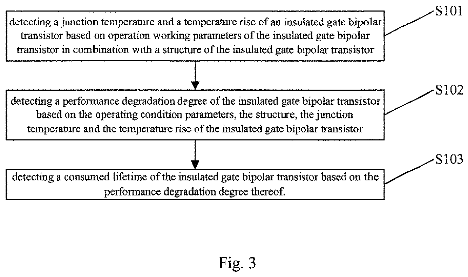

Further, the present embodiment further provides an on-line health management method for the IGBT. As shown in Fig. 3, the method comprises step S101, step S102 and step S103. In step S101, a junction temperature and a temperature rise of an insulated gate bipolar transistor is detected based on operating condition parameters of the insulated gate bipolar transistor in combination with a structure of the insulated gate bipolar transistor. In step S102, a performance degradation degree of the insulated gate bipolar transistor is detected based on the operating condition parameters, the structure, the junction temperature and the temperature rise of the insulated gate bipolar transistor. In step S103, a consumed lifetime of the insulated gate bipolar transistor is detected based on the performance degradation degree thereof.

The above embodiments are described only for better understanding, rather than restricting the present disclosure. Any person skilled in the art can make amendments and changes to the implementing forms or details without departing from the scope of the present disclosure. The protection scope of the present disclosure shall be determined by the scope as defined in the claims.

**Claims**

1. An on-line health management device for an insulated gate bipolar transistor, wherein the on-line health management device comprises:

   a sampling module, configured to sample the operating condition parameters of the insulated gate bipolar transistor;
   an extremum detection module, configured to detect whether the operating condition parameters each are within a corresponding extremum range or not, wherein if the operating condition parameters each are within a corresponding extremum range, the operating condition parameters are sent to the electrothermal detection module;
   an electrothermal detection module, configured to detect a junction temperature and a temperature rise of the insulated gate bipolar transistor based on operating condition parameters of the insulated gate bipolar transistor in combination with a structure of the insulated gate bipolar transistor;
   a degradation detection module, configured to detect a performance degradation degree of the insulated gate bipolar transistor based on the operating condition parameters, the structure, the junction temperature and the temperature rise of the insulated gate bipolar transistor; and
   a lifetime detection module, configured to detect a consumed lifetime of the insulated gate bipolar transistor based on the performance degradation degree thereof.

2. The on-line health management device according to claim 1, further comprising:
   a warning module, configured to detect whether the consumed lifetime is larger than or equal to a preset lifetime, wherein if the consumed lifetime is larger than or equal to the preset lifetime, a failure warning is provided.

3. The on-line health management device according to claim 2, **characterized in that**:

   if the extremum detection module detects that an operation condition parameter is beyond a corresponding extremum range, a detection result is sent to the warning module; and
   the warning module is further configured to provide a failure warning based on the detection result of the extremum detection module.

4. The on-line health management device according to any of claims 1 to 3, wherein the operating condition parameters at least include current, voltage, and working temperature.

5. The on-line health management device according to claim 4, wherein the degradation detection module is configured to detect the performance degradation degree of the insulated gate bipolar transistor based on failure working cycles corresponding to the operating condition parameters, the structure, the junction temperature and the temperature rise of the insulated gate bipolar transistor in combination with proportion corresponding to the operating condition parameters, the structure, the junction temperature and the temperature rise of the insulated gate bipolar transistor.

6. An on-line health management method for an insulated gate bipolar transistor, wherein the on-line health management method comprises steps of:

   sampling the operating condition parameters of the insulated gate bipolar transistor;
   detecting whether the operating condition parameters each are within a corresponding extremum range or not, wherein if the operating condition parameters each are within a corresponding extremum range, the operating condition parameters are sent to the electrothermal detection module;
   detecting (S101) a junction temperature and a temperature rise of the insulated gate bipolar transistor based on operating condition parameters of the insulated gate bipolar transistor in combination with a structure of the insulated gate bipolar transistor;
   detecting (S102) a performance degradation degree of the insulated gate bipolar transistor based on the operating condition parameters, the structure, the junction temperature and the temperature rise of the insulated gate bipolar transistor; and
   detecting (S103) a consumed lifetime of the insulated gate bipolar transistor based on the performance degradation degree thereof.

7. The on-line health management method according to claim 6, further comprising a step of:
   detecting an operation state of the insulated gate bipolar transistor based on the performance degradation degree.

8. The on-line health management method according to claim 6, wherein if it is detected that an operation condition parameter is beyond a corresponding extremum range, the on-line health management method further comprises a step of:
   providing a failure warning based on a detection result of the extremum detection module.

**Patentansprüche**

1. Online-Gesundheitsverwaltungsvorrichtung für einen Bipolartransistor mit isolierter Gate-Elektrode, wobei die Online-Gesundheitsverwaltungsvorrichtung Folgendes umfasst:

   ein Abfragemodul, das dazu ausgelegt ist, die Betriebszustandsparameter des Bipolartransistors mit isolierter Gate-Elektrode abzufragen;
   ein Extremdetektionsmodul, das dazu ausgelegt ist, zu detektieren, ob die Betriebszustandsparameter jeweils innerhalb einer entsprechenden Extremspanne sind oder nicht, wobei, falls die Betriebszustandsparameter jeweils innerhalb einer entsprechenden Extremspanne sind, die Betriebszustandsparameter an das elektrothermische Detektionsmodul gesendet werden;
   ein elektrothermisches Detektionsmodul, das dazu ausgelegt ist, eine Übergangstemperatur und einen Temperaturanstieg des Bipolartransistors mit isolierter Gate-Elektrode auf Basis von Betriebszustandsparametern des Bipolartransistors mit isolierter Gate-Elektrode in Kombination mit einer Struktur des Bipolartransistors mit isolierter Gate-Elektrode zu detektieren;
   ein Verschlechterungsdetektionsmodul, das dazu ausgelegt ist, einen Leistungsverschlechterungsgrad des Bipolartransistors mit isolierter Gate-Elektrode auf Basis der Betriebszustandsparameter, der Struktur, der Übergangstemperatur und des Temperaturanstiegs des Bipolartransistors mit isolierter Gate-Elektrode zu detektieren; und
   ein Lebensdauerdetektionsmodul, das dazu ausgelegt ist, eine verbrauchte Lebensdauer des Bipolartransistors mit isolierter Gate-Elektrode auf Basis seines Leistungsverschlechterungsgrads zu detektieren.

2. Online-Gesundheitsverwaltungsvorrichtung nach Anspruch 1, die weiter Folgendes umfasst:
   ein Warnmodul, das dazu ausgelegt ist, zu detektieren, ob die verbrauchte Lebensdauer größer als oder gleich einer vorgegebenen Lebensdauer ist, wobei, falls die verbrauchte Lebensdauer größer als oder gleich der vorgegebenen Lebensdauer ist, eine Ausfallwarnung bereitgestellt wird.

3. Online-Gesundheitsverwaltungsvorrichtung nach Anspruch 2, **dadurch gekennzeichnet, dass**:

   falls das Extremdetektionsmodul detektiert, dass ein Betriebszustandsparameter außerhalb eines entsprechenden Extrembereichs ist, ein Detektionsergebnis an das Warnmodul gesendet wird; und
   das Warnmodul weiter dazu ausgelegt ist, eine Ausfallwarnung auf Basis des Detektionsergebnisses des Extremdetektionsmoduls bereitzustellen.

4. Online-Gesundheitsverwaltungsvorrichtung nach einem der Ansprüche 1 bis 3, wobei die Betriebszustandsparameter zumindest Stromstärke, Spannung und Betriebstemperatur beinhalten.

5. Online-Gesundheitsverwaltungsvorrichtung nach Anspruch 4, wobei das Verschlechterungsdetektionsmodul dazu ausgelegt ist, den Leistungsverschlechterungsgrad des Bipolartransistors mit isolierter Gate-Elektrode auf Basis von Ausfallbetriebszyklen entsprechend den Betriebszustandsparametern, der Struktur, der Übergangstemperatur und des Temperaturanstiegs des Bipolartransistors mit isolierter Gate-Elektrode in Kombination mit Proportion entsprechend den Betriebszustandsparametern, der Struktur, der Übergangstemperatur und des Temperaturanstiegs des Bipolartransistors mit isolierter Gate-Elektrode zu detektieren.

6. Online-Gesundheitsverwaltungsverfahren für einen Bipolartransistor mit isolierter Gate-Elektrode, wobei das Online-Gesundheitsverwaltungsverfahren die folgenden Schritte umfasst:

Abfragen der Betriebszustandsparameter des Bipolartransistors mit isolierter Gate-Elektrode;

Detektieren, ob die Betriebszustandsparameter jeweils innerhalb eines entsprechenden Extrembereichs sind oder nicht, wobei, falls die Betriebszustandsparameter jeweils innerhalb eines entsprechenden Extrembereichs sind, die Betriebszustandsparameter an das elektrothermische Detektionsmodul gesendet werden;

Detektieren (S101) einer Übergangstemperatur und eines Temperaturanstiegs des Bipolartransistors mit isolierter Gate-Elektrode auf Basis von Betriebszustandsparametern des Bipolartransistors mit isolierter Gate-Elektrode in Kombination mit einer Struktur des Bipolartransistors mit isolierter Gate-Elektrode;

Detektieren (S102) eines Leistungsverschlechterungsgrads des Bipolartransistors mit isolierter Gate-Elektrode auf Basis der Betriebszustandsparameter, der Struktur, der Übergangstemperatur und des Temperaturanstiegs des Bipolartransistors mit isolierter Gate-Elektrode; und

Detektieren (S103) einer verbrauchten Lebensdauer des Bipolartransistors mit isolierter Gate-Elektrode auf Basis seines Leistungsverschlechterungsgrads.

**7.** Online-Gesundheitsverwaltungsverfahren nach Anspruch 6, das weiter einen folgenden Schritt umfasst:

Detektieren eines Betriebszustands des Bipolartransistors mit isolierter Gate-Elektrode auf Basis des Leistungsverschlechterungsgrads.

**8.** Online-Gesundheitsverwaltungsverfahren nach Anspruch 6, wobei, falls detektiert wird, dass ein Betriebszustandsparameter außerhalb eines entsprechenden Extrembereichs ist, das Online-Gesundheitsverwaltungsverfahren weiter einen folgenden Schritt umfasst:

Bereitstellen einer Ausfallwarnung auf Basis eines Detektionsergebnisses des Extremdetektionsmoduls.

## Revendications

**1.** Dispositif de gestion de santé en ligne pour un transistor bipolaire à grille isolée, dans lequel le dispositif de gestion de santé en ligne comprend :

un module d'échantillonnage, configuré pour échantillonner les paramètres de condition de fonctionnement du transistor bipolaire à grille isolée ;

un module de détection d'extremum, configuré pour détecter si les paramètres de condition de fonctionnement sont chacun dans une plage d'extremum correspondante ou non, dans lequel si les paramètres de condition de fonctionnement sont chacun dans une plage d'extremum correspondante, les paramètres de condition de fonctionnement sont envoyés au module de détection électrothermique ;

un module de détection électrothermique, configuré pour détecter une température de jonction et une élévation de température du transistor bipolaire à grille isolée sur la base de paramètres de condition de fonctionnement du transistor bipolaire à grille isolée en combinaison avec une structure du transistor bipolaire à grille isolée ;

un module de détection de dégradation, configuré pour détecter un degré de dégradation de performances du transistor bipolaire à grille isolée sur la base des paramètres de condition de fonctionnement, de la structure, de la température de jonction et de l'élévation de température du transistor bipolaire à grille isolée ; et

un module de détection de durée de vie, configuré pour détecter une durée de vie consommée du transistor bipolaire à grille isolée sur la base du degré de dégradation de performances de celui-ci.

**2.** Dispositif de gestion de santé en ligne selon la revendication 1, comprenant en outre :

un module d'avertissement, configuré pour détecter si la durée de vie consommée est supérieure ou égale à une durée de vie prédéfinie, dans lequel si la durée de vie consommée est supérieure ou égale à la durée de vie prédéfinie, un avertissement de défaillance est fourni.

**3.** Dispositif de gestion de santé en ligne selon la revendication 2, **caractérisé en ce que** :

si le module de détection d'extremum détecte qu'un paramètre de condition de fonctionnement est au-delà d'une plage d'extremum correspondante, un résultat de détection est envoyé au module d'avertissement ; et

le module d'avertissement est configuré en outre pour fournir un avertissement de défaillance sur la base du résultat de détection du module de détection d'extremum.

**4.** Dispositif de gestion de santé en ligne selon l'une quelconque des revendications 1 à 3, dans lequel les paramètres de condition de fonctionnement incluent au moins un courant, une tension, et une température de travail.

**5.** Dispositif de gestion de santé en ligne selon la revendication 4, dans lequel le module de détection de dégradation est configuré pour détecter le degré de dégradation de performances du transistor bipolaire à grille isolée sur la base de cycles de travail de défaillance correspondant aux paramètres de condition de fonctionnement, à la structure, à la température de jonction et à l'élévation de température du transistor bipolaire à grille isolée en combinaison avec une proportion correspondant aux paramètres de condition de fonctionnement, à la structure, à la température de jonction et à l'élévation de température du transistor bipolaire à grille isolée.

**6.** Procédé de gestion de santé en ligne pour un transistor bipolaire à grille isolée, dans lequel le procédé de gestion de santé en ligne comprend les étapes consistant à :

échantillonner les paramètres de condition de fonctionnement du transistor bipolaire à grille isolée ;
détecter si les paramètres de condition de fonctionnement sont chacun dans une plage d'extremum correspondante ou non, dans lequel si les paramètres de condition de fonctionnement sont chacun dans une plage d'extremum correspondante, les paramètres de condition de fonctionnement sont envoyés au module de détection électrothermique ;
détecter (S101) une température de jonction et une élévation de température du transistor bipolaire à grille isolée sur la base de paramètres de condition de fonctionnement du transistor bipolaire à grille isolée en combinaison avec une structure du transistor bipolaire à grille isolée ;
détecter (S102) un degré de dégradation de performances du transistor bipolaire à grille isolée sur la base des paramètres de condition de fonctionnement, de la structure, de la température de jonction et de l'élévation de température du transistor bipolaire à grille isolée ; et
détecter (S103) une durée de vie consommée du transistor bipolaire à grille isolée sur la base du degré de dégradation de performances de celui-ci.

**7.** Procédé de gestion de santé en ligne selon la revendication 6, comprenant en outre une étape consistant à :
détecter un état de fonctionnement du transistor bipolaire à grille isolée sur la base du degré de dégradation de performances.

**8.** Procédé de gestion de santé en ligne selon la revendication 6, dans lequel s'il est détecté qu'un paramètre de condition de fonctionnement est au-delà d'une plage d'extremum correspondante, le procédé de gestion de santé en ligne comprend en outre une étape consistant à :
fournir un avertissement de défaillance sur la base d'un résultat de détection du module de détection d'extremum.

Fig. 1

Fig. 2

detecting a junction temperature and a temperature rise of an insulated gate bipolar transistor based on operation working parameters of the insulated gate bipolar transistor in combination with a structure of the insulated gate bipolar transistor

S101

detecting a performance degradation degree of the insulated gate bipolar transistor based on the operating condition parameters, the structure, the junction temperature and the temperature rise of the insulated gate bipolar transistor

S102

detecting a consumed lifetime of the insulated gate bipolar transistor based on the performance degradation degree thereof.

S103

Fig. 3

**REFERENCES CITED IN THE DESCRIPTION**

**Patent documents cited in the description**

- DE 102011087764 A1
- US 8103463 B2
- JP 2007028741 A
- CN 104933308 A